# EUROPEAN PATENT APPLICATION

(11) **EP 4 560 689 A1**
(43) Date of publication of application: **28.05.2025**
(21) Application number: 24214510.0
(22) Date of filing: 21.11.2024
(51) Int. Cl.: H01L 21/768, H01L 23/528, H10D 89/10

(54) **BEOL FABRICATION METHOD INCLUDING REMOVING DUMMY LINES**

(30) Priority: 27.11.2023 US 202363602946 P; 01.05.2024 US 202418652000
(71) Applicant: Samsung Electronics Co., Ltd., Suwon-si, Gyeonggi-do 16677 (KR)
(72) Inventor: CHOI, Jaemyung, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Methods of forming a back-end-of-line, BEOL, region of an integrated circuit, IC, device are provided. A method of forming a BEOL region of an IC device includes converting (412) a non-full-track standard cell designed for the BEOL region to a full-track standard cell by adding dummy metal lines to the non-full-track standard cell. The method includes removing (416) the dummy metal lines. Moreover, the method includes forming (418) top vias after removing the dummy metal lines.

## Description

### TECHNICAL FIELD

The present disclosure generally relates to the field of integrated circuit (IC) devices and, more particularly, to metal lines in a back-end-of-line (BEOL) region of an IC device.

### BACKGROUND OF THE INVENTION

A BEOL region of an IC device may include multiple vertical levels of metal lines (e.g., interconnect wires). Upper metal lines in the BEOL region may be coupled to lower metal lines in the BEOL region by metal vias. When forming a standard cell for the BEOL region, the use of a full-track design, in which all signal-line areas are filled with metal, may increase process margin (e.g., metal patterning process margin) relative to a non-full-track design, in which at least one of the signal-line areas has an opening therein. The full-track design, however, may result in higher capacitance (due to the increased amount of metal) than the non-full-track design.

### SUMMARY OF THE INVENTION

A method of forming a BEOL region of an IC device, according to some embodiments herein, may include converting a non-full-track standard cell designed for the BEOL region to a full-track standard cell by adding dummy metal lines to the non-full-track standard cell. The method may include performing metal patterning based on the full-track standard cell. The method may include removing the dummy metal lines after performing the metal patterning. Moreover, the method may include forming top vias after removing the dummy metal lines.

A method of forming a BEOL region of an IC device, according to some embodiments herein, may include designing non-dummy metal lines in respective signal-line areas of the BEOL region. The method may include designing dummy metal lines in openings in at least some of the signal-line areas, after designing the non-dummy metal lines. The method may include performing metal patterning on the signal-line areas, after designing the dummy metal lines. The method may include removing the dummy metal lines after performing the metal patterning. Moreover, the method may include forming a top via in at least one of the signal-line areas after removing the dummy metal lines.

A method of forming a BEOL region of an IC device, according to some embodiments herein, may include forming a non-full-track standard cell design for the BEOL region. The method may include converting the non-full-track standard cell design to a full-track standard cell design by adding dummy metal lines to the non-full-track standard cell design. Adding the dummy metal lines may include designing metal in all openings in signal-line areas of the non-full-track standard cell design. The method may include removing the dummy metal lines by performing a subtractive metal etch of the dummy metal lines. Moreover, the method may include forming top vias after removing the dummy metal lines.

### BRIEF DESCRIPTION OF THE DRAWINGS

FIG. 1A is a schematic block diagram of an IC device according to some embodiments herein.
FIG. 1B is an example plan view of a non-full-track standard cell of the BEOL region of the IC device of FIG. 1A.
FIG. 1C is a cross-sectional view of the non-full-track standard cell of FIG. 1B along line A-A'.
FIG. 1D is a cross-sectional view of the non-full-track standard cell of FIG. 1B along line B-B'.
FIGs. 2A-2C are plan views, and FIGs. 2D-2N are cross-sectional views, illustrating operations of forming the standard cell of FIGs. 1B-1D according to some embodiments herein.
FIGs. 3A and 3B are cross-sectional views illustrating an operation of removing dummy metal lines according to some embodiments herein.
FIGs. 3C and 3D are plan views of a signal-line area from which a dummy metal line is removed using the operation shown in FIGs. 3A and 3B according to some embodiments herein.
FIG. 4 is a flowchart corresponding to the operations shown in FIGs. 2A-2N.

### DETAILED DESCRIPTION

Pursuant to embodiments herein, a method of forming a BEOL region of an IC device is provided that includes forming dummy metal lines that are subsequently removed. For example, the dummy metal lines may be designed to convert a non-full-track standard cell of the BEOL region into a full-track standard cell of the BEOL region, and the dummy metal lines may be physically removed after performing metal patterning based on (e.g., based on a digital design of) the full-track standard cell. Removing the dummy metal lines can convert the full-track standard cell back into the non-full-track standard cell. Process margin can increase by performing metal patterning based on the full-track standard cell (instead of the non-full-track standard cell), and capacitance can decrease by converting the full-track standard cell back into the non-full-track standard cell (which has less metal than the full-track standard cell) after performing the metal patterning. Accordingly, a method that includes adding and removing dummy metal lines can advantageously benefit from the higher process margin of a full-track design without suffering the capacitance penalty that can result from increased metal in the full-track design.

Example embodiments will be described in greater detail with reference to the attached figures.

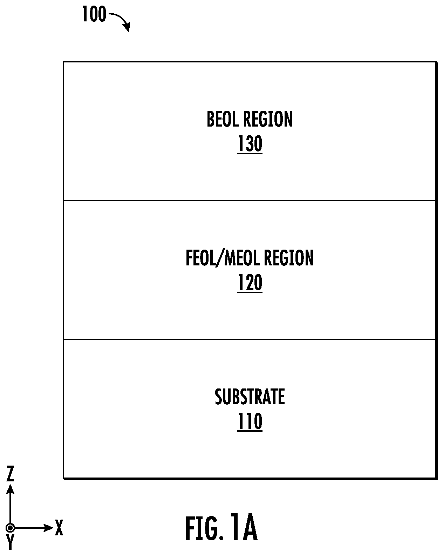

FIG. 1A is a schematic block diagram of an IC device 100 according to some embodiments. The IC device 100 may be, for example, a semiconductor memory device for storing data and/or a semiconductor logic device for processing data. The IC device 100 includes a substrate (e.g., a semiconductor substrate) 110, a BEOL region 130 that is on the substrate 110, and a front-end-of-line (FEOL) and/or middle-end-of-line (MEOL) region 120 that is between (in a vertical direction Z) the BEOL region 130 and the substrate 110. As an example, the FEOL/MEOL region 120 may include devices such as transistors, capacitors, and/or resistors. Moreover, the BEOL region 130 may include interconnect wires, vias, and dielectric structures.

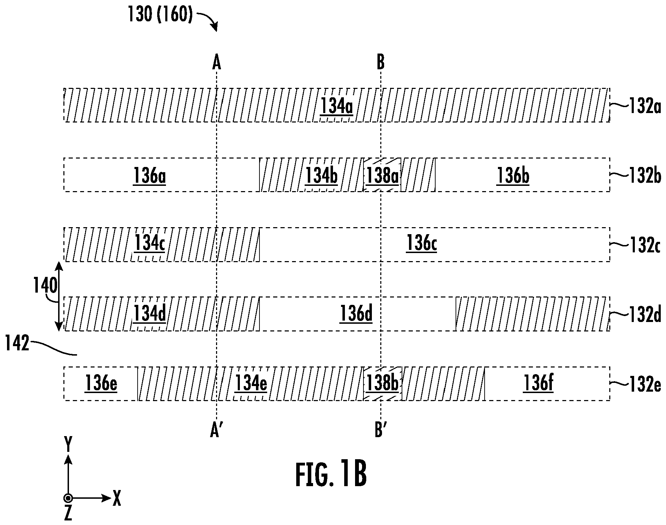

FIG. 1B is an example plan view of a non-full-track standard cell 160 of the BEOL region 130. The non-full-track standard cell 160 includes metal signal lines 134a-134e in respective signal-line areas 132a-132e. Moreover, some of the signal-line areas 132 include openings 136 that are free of metal. For example, the signal-line area 132b includes openings 136a and 136b, the signal-line area 132c includes opening 136c, the signal-line area 132d includes opening 136d, and the signal-line area 132e includes openings 136e and 136f. The signal lines 134b-134e thus do not completely fill (e.g., do not extend continuously in a horizontal direction X between opposite ends of) the signal-line areas 132b-132e, respectively. The openings 136 differentiate the non-full-track standard cell 160 from a full-track standard cell, in which each signal-line area 132 is full of metal and has no opening 136 therein.

The signal lines 134 may extend longitudinally in the direction X in parallel with each other. The signal-line areas 132 are spaced apart from each other by spaces (e.g., metal-free gaps) 142 in another horizontal (i.e., lateral) direction Y that intersects (e.g., is perpendicular to) the directions X and Z. According to some embodiments, the signal lines 134a-134e may have a pitch 140 in the direction Y that may be a constant pitch. Moreover, as used herein, the term "signal-line area" refers to a portion of a standard cell of the BEOL region 130 that will be completely filled by a signal line 134 if the standard cell is a full-track standard cell.

The signal lines 134b, 134e have respective metal vias 138a, 138b thereon. The vias 138 may couple the signal lines 134 to an upper layer of metal lines that is omitted from view in FIG. 1B for simplicity of illustration. For example, the signal lines 134 may be lower metal lines of the BEOL region 130, and the vias 138 may couple the lower metal lines to upper metal lines of the BEOL region 130. Accordingly, the BEOL region 130 may comprise a variety of BEOL elements, including various metal lines (e.g., metal/interconnect wires) and metal vias.

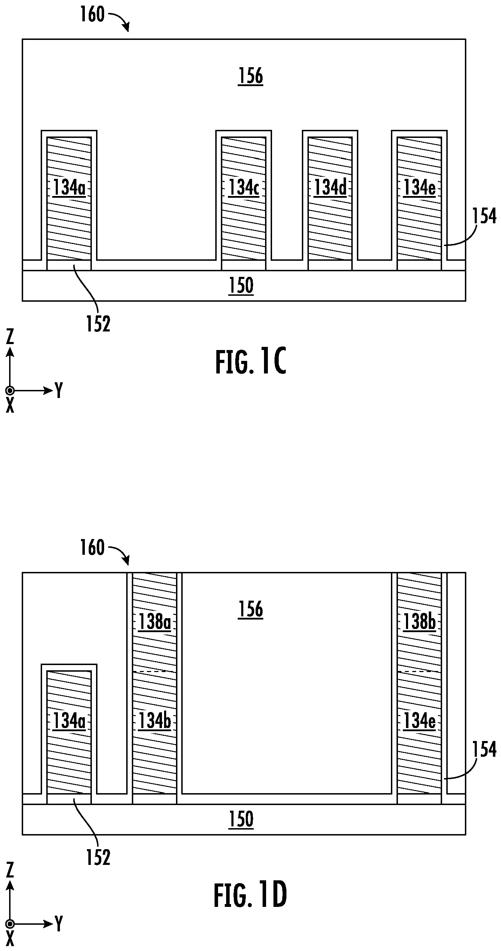

FIG. 1C is a cross-sectional view of the non-full-track standard cell 160 along line A-A' of FIG. 1B. As shown in FIG. 1C, the signal lines 134 are at the same vertical level, in the direction Z. For example, the signal lines 134 may be lower metal lines that are each at a low (e.g., lowest) level among metal lines of the BEOL region 130 (FIG. 1A).

The signal line 134b (FIG. 1B) is not shown in FIG. 1C, as the line A-A' passes through the opening 136a (FIG. 1B) that is in the signal-line area 132b (FIG. 1B). The opening 136a may comprise a first insulating layer 156 therein, and may be free of metal. As an example, the opening 136a may be filled with the insulating layer 156, or with a combination of the insulating layer 156 and another insulating layer. The insulating layer 156 may also be on sidewalls and uppermost surfaces of the signal lines 134a and 134c-134e.

According to some embodiments, a first metal adhesion layer 152 may be on lowermost surfaces of the signal lines 134. Moreover, the metal lines 134 may be on a second insulating layer 150, and the adhesion layer 152 may be between, in the vertical direction Z, the metal lines 134 and the second insulating layer 150. The adhesion layer 152 may enhance adhesion between the metal lines 134 and the second insulating layer 150.

In some embodiments, a second metal adhesion layer 154 may be between the first insulating layer 156 and the sidewalls and uppermost surfaces of the signal lines 134a and 134c-134e. For example, the second adhesion layer 154 may be a thin, conformal layer, whereas the first insulating layer 156 may fill gaps between the signal lines 134. In some embodiments, the adhesion layer 154 may have a thickness similar (or equal) to that of the adhesion layer 152. The adhesion layer 154 may enhance adhesion between the metal lines 134 and the first insulating layer 156.

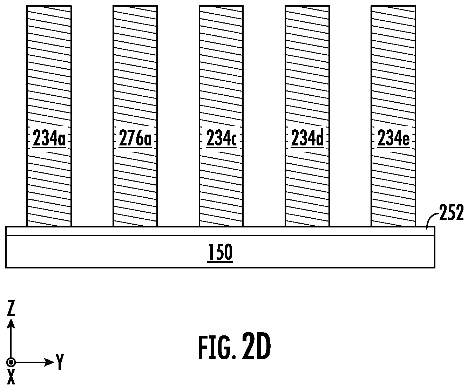

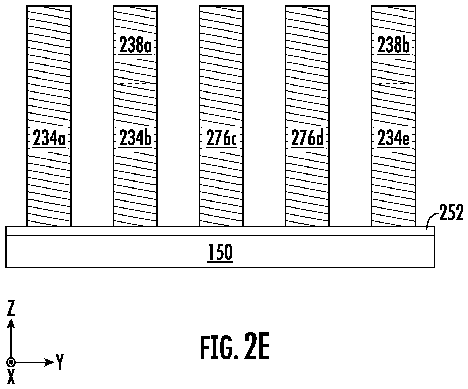

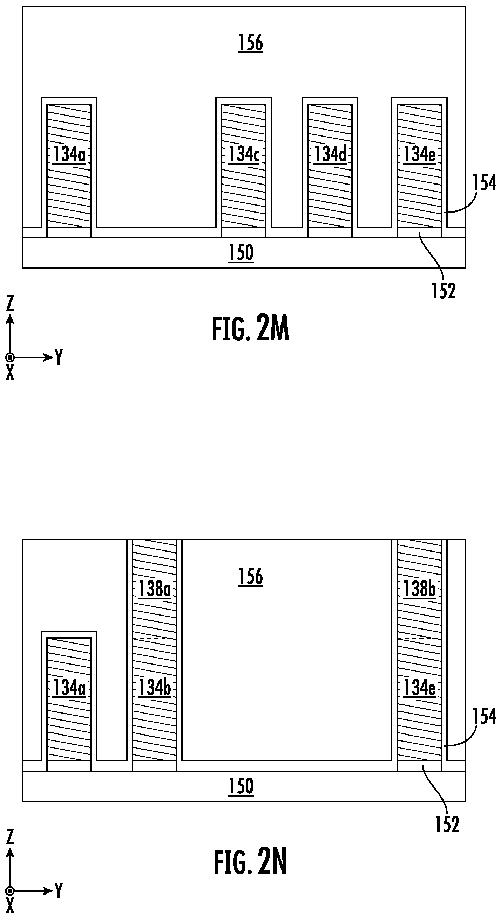

The insulating layers 150, 156 may, in some embodiments, each comprise a different insulating material. Example materials of the adhesion layers 152, 154 and the insulating layers 150, 156 are described herein with respect to FIGs. 2D, 2E, 2M, and 2N.

FIG. 1D is a cross-sectional view of the non-full-track standard cell 160 along line B-B' of FIG. 1B. As shown in FIG. 1D, the vias 138 are at the same vertical level, in the direction Z, and this level is above the vertical level of the signal lines 134. For example, the vias 138 may each be at a middle level of the BEOL region 130 (FIG. 1A). The middle level may be between, in the direction Z, the level of the signal lines 134 and a level of upper metal lines, which are omitted from view in FIG. 1D for simplicity of illustration. As an example, the upper metal lines may be at a high (e.g., highest) level of the BEOL region 130.

Moreover, the adhesion layer 154 and the insulating layer 156 may be on sidewalls of the vias 138. The signal lines 134c, 134d (FIG. 1B) are not shown in FIG. 1D, as the line B-B' passes through the openings 136c, 136d (FIG. 1B) that are in the signal-line areas 132c, 132d (FIG. 1B). The openings 136c, 136d may comprise the insulating layer 156 therein, and may be free of metal. For example, the openings 136c, 136d may be filled with the insulating layer 156, or with a combination of the insulating layer 156 and the adhesion layer 154.

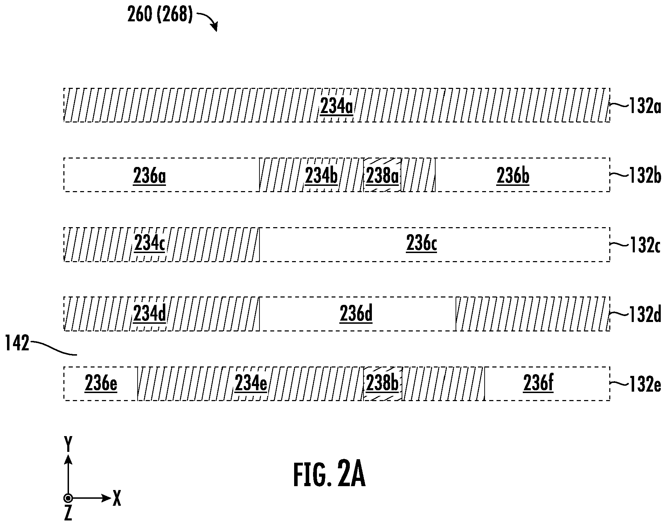

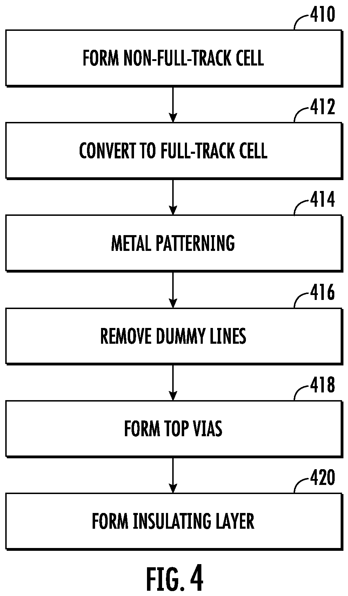

FIGs. 2A-2C are plan views, and FIGs. 2D-2N are cross-sectional views, illustrating operations of forming the standard cell 160 of FIGs. 1B-1D according to some embodiments herein. FIG. 4 is a flowchart corresponding to the operations shown in FIGs. 2A-2N.

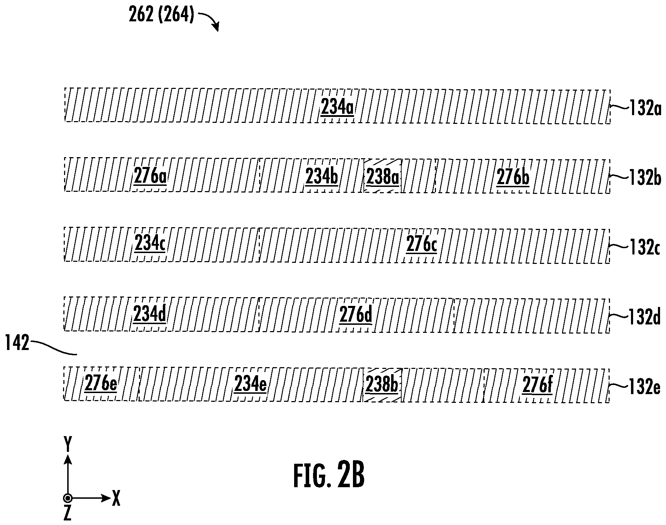

As shown in FIGs. 2A and 4, a non-full-track standard cell 260 may be designed/formed (Block 410) for the BEOL region 130 (FIG. 1A). For example, a human circuit-designer may provide a digital design 268 of the standard cell 260. The standard cell 260 includes signal-line areas 132 that have openings 236 therein. The signal-line areas 132 are thus not completely filled with metal. For example, the signal-line area 132b may include openings 236a and 236b, the signal-line area 132c may include opening 236c, the signal-line area 132d may include opening 236d, and the signal-line area 132e may include openings 236e and 236f. The signal-line areas 132a-132e include metal lines 234a-234e, respectively. To distinguish the metal lines 234 from dummy metal lines 276 (FIG. 2B) that will subsequently be designed/formed in the signal-line areas 132, the metal lines 234 may be referred to herein as "non-dummy" metal lines, which may be required for the IC device 100 (FIG. 1A) to operate. Moreover, though the dummy metal lines 276 include metal, they are not required for the IC device 100 to operate, and thus may be referred to herein as "dummy" metal lines.

As shown in FIGs. 2B and 4, the non-full-track standard cell 260 of FIG. 2A may be converted (Block 412) to a full-track standard cell 262 (e.g., a digital design 264 thereof) by adding dummy metal lines 276 to the standard cell 260. For example, the dummy metal lines 276 may be designed/formed by filling all of the openings 236 (FIG. 2A) in the signal-line areas 132 with metal. As shown in FIG. 2B, dummy metal lines 276a-276f may be added to (e.g., may fill) the openings 236a-236f (FIG. 2A), respectively. End portions of the dummy metal lines 276 may contact end portions of the metal lines 234, and the signal-line areas 132 may thus be continuously metal between opposite ends of each signal-line area 132.

In some embodiments, the metal lines 234 and the dummy metal lines 276 may each comprise the same metal. As an example, the metal lines 234 and the dummy metal lines 276 may each comprise ruthenium (Ru). In other examples, the metal lines 234 and the dummy metal lines 276 may each comprise rhodium (Rh) or iridium (Ir). Accordingly, no interface may be visible between the metal lines 234 and the dummy metal lines 276. To differentiate between the metal lines 234 and the dummy metal lines 276, however, interfaces are shown in FIG. 2B between the metal lines 234 and the dummy metal lines 276.

According to some embodiments, the metal lines 234 and the dummy metal lines 276 may each have the same height in the direction Z. Accordingly, uppermost surfaces of the metal lines 234 may be coplanar with uppermost surfaces of the dummy metal lines 276. To indicate locations where metal vias 138 (FIG. 1B) will subsequently be formed, however, FIGs. 2A and 2B show via positions 238a, 238b. FIGs. 2A and 2B also show spaces 142 by which the signal-line areas 132 are separated from each other in the direction Y.

In some embodiments, operations of forming (Block 410) the non-full-track standard cell 260 and converting (Block 412) it to a full-track standard cell 262 by adding dummy metal lines 276 may be performed digitally rather than physically. For example, a human circuit-designer may use software (e.g., design-tool software) to perform these operations. As an example, operation(s) of designing/forming the dummy metal lines 276 by filling all of the openings 236 (FIG. 2A) in the signal-line areas 132 with metal may comprise digitally (rather than physically) filling the openings 236 in a digital design for the full-track standard cell 262. The non-full-track standard cell 260 and the full-track standard cell 262 shown in FIGs 2A and 2B may thus be digital designs 268 and 264 (i.e., designs that exist in digital data), respectively. Subsequent operations (e.g., Blocks 414-420), by contrast, may be performed physically (e.g., by physical patterning of metal) based on the digital design 264 (of the full-track standard cell 262 having dummy metal lines 276) that the designer creates.

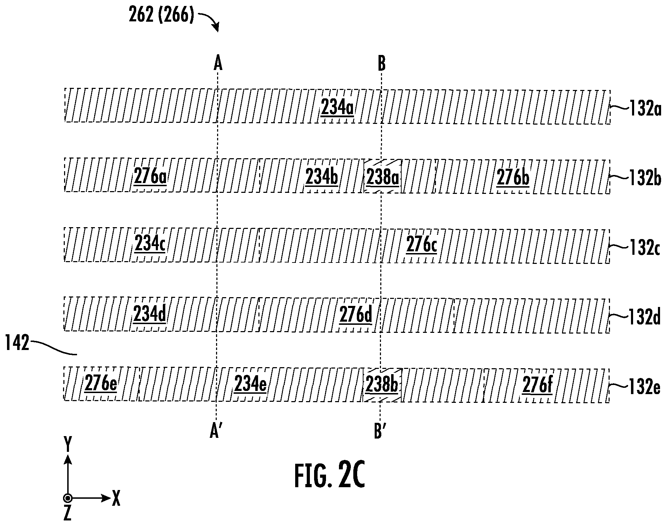

As shown in FIGs. 2C-2E and 4, metal patterning (Block 414) may be performed with respect to the full-track standard cell 262 (e.g., based on the digital design 264 (FIG. 2B) thereof). As an example, the metal patterning may include performing Ru patterning on an Ru block/layer to form the full-track standard cell 262 (e.g., to form Ru metal lines 234 and/or Ru dummy metal lines 276). The metal patterning may provide a physical (rather than digital) structure 266 of the full-track standard cell 262. FIG. 2D is a cross-sectional view along line A-A' of FIG. 2C, and FIG. 2E is a cross-sectional view along line B-B' of FIG. 2C. FIGs. 2D and 2E show that the metal lines 234 and the dummy metal lines 276 may have coplanar uppermost surfaces. Moreover, FIG. 2E shows the via position 238a, which is a portion of the metal line 234b where a metal via 138 (FIG. 1B) will subsequently be formed, and the via position 238b, which is a portion of the metal line 234e where another metal via 138 will subsequently be formed. In some embodiments, the metal patterning may include performing self-aligned universal patterning (SAUP) for (e.g., to form the physical structure 266 (FIG. 2C) of) the full-track standard cell 262. According to some embodiments, the metal patterning may include performing litho-etch-litho-etch (LELE) patterning for (e.g., to form the physical structure 266 of) the full-track standard cell 262. As an example, the metal patterning may be SA-LELE, which is a type of SAUP.

FIGs. 2D and 2E also show that the metal lines 234 and the dummy metal lines 276 may be on a metal adhesion layer 252. For example, the adhesion layer 252 may be formed on an insulating layer 150, and then the metal lines 234 and the dummy metal lines 276 may be formed on the metal adhesion layer 252. The adhesion layer 252 may comprise a metal that improves adhesion of the metal lines 234 and the dummy metal lines 276 to the insulating layer 150. As an example, the adhesion layer 252 may comprise aluminum (Al) or chromium (Cr). Moreover, the adhesion layer 252 may comprise a nitride (e.g., metal nitride) layer. The adhesion layer 252 will subsequently be patterned/etched to form the adhesion layer 152 (FIG. 1C). The insulating layer 150 may comprise, for example, an oxide layer or a nitride layer.

As described herein, operations of forming (Block 410) the non-full-track standard cell 260 and converting (Block 412) it to a full-track standard cell 262 may be performed digitally rather than physically. Accordingly, performing metal patterning based on the full-track standard cell 262 may comprise patterning a block of metal to form the spaces 142, the metal lines 234, and the dummy metal lines 276, based on the digital design 264 (FIG. 2B) of the full-track standard cell 262. The spaces 142, the metal lines 234, and the dummy metal lines 276 thus may not physically exist (in the physical structure 266 (FIG. 2C)) until performing metal patterning.

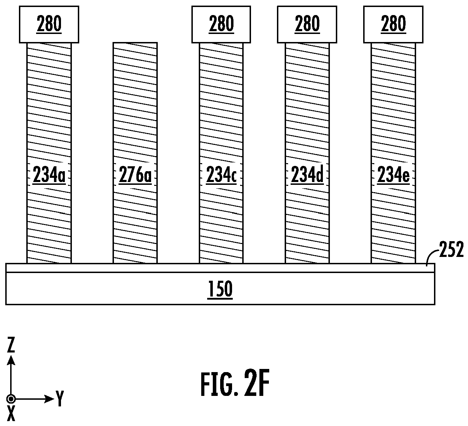

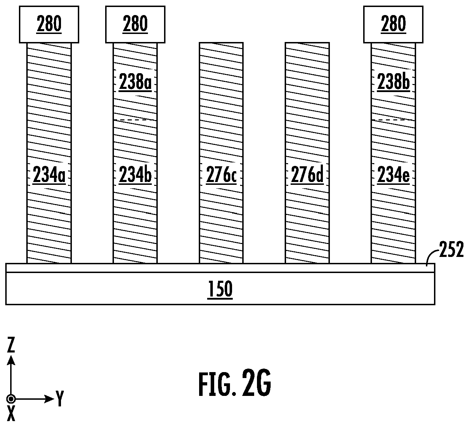

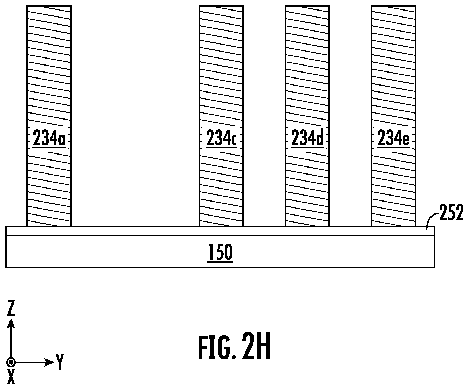

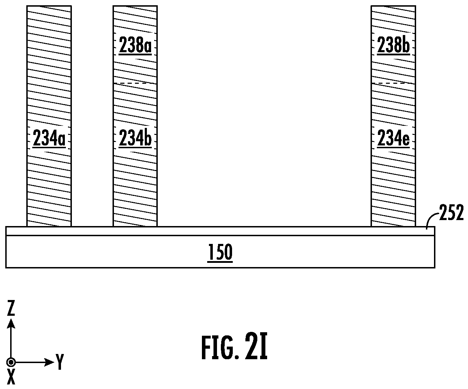

As shown in FIGs. 2F-2I and 4, the dummy metal lines 276 may be removed (Block 416) after performing metal patterning (FIG. 2C). Removing the dummy metal lines 276 forms openings 236 (FIG. 2A) in at least some (e.g., at least two, but not necessarily all) of the signal-line areas 132 (FIG. 2A), and thereby converts the full-track standard cell 262 back into the non-full-track standard cell 260 (FIG. 2A). FIGs. 2F and 2H are cross-sectional views showing operations that occur along line A-A' (FIG. 2C) after the metal patterning. FIGs. 2G and 2I are cross-sectional views showing operations that occur along line B-B' (FIG. 2C) after the metal patterning.

In some embodiments, removing the dummy metal lines 276 may include forming a blocking pattern 280 that vertically overlaps all (non-dummy) metal lines 234 of the full-track standard cell 262 and none of the dummy metal lines 276, as shown in FIGs. 2F and 2G. Accordingly, uppermost surfaces of the dummy metal lines 276 are exposed by the blocking pattern 280 while uppermost surfaces of the metal lines 234 are covered by the blocking pattern 280. The blocking pattern 280 may be an insulating material that has an etch selectivity relative to the dummy metal lines 276 and relative to the adhesion layer 252. Moreover, the blocking pattern 280 may be absent from sidewalls of the metal lines 234 and from sidewalls of the dummy metal lines 276. As a result, a relatively small amount of the material of the blocking pattern 280 may be used, which may reduce costs. According to some embodiments, the blocking pattern 280 may include multiple spaced-apart portions, each of which is narrower, in the direction Y, than a pitch of the metal lines 234.

Removal of the dummy metal lines 276 may be performed by a subtractive metal (e.g., subtractive Ru) etch of the dummy metal lines 276 while the blocking pattern 280 vertically overlaps the metal lines 234. FIG. 2H shows that the dummy metal line 276a has been removed from between the metal lines 234a, 234c. FIG. 2I shows that the dummy metal lines 276c, 276d have been removed from between the metal lines 234b, 234e.

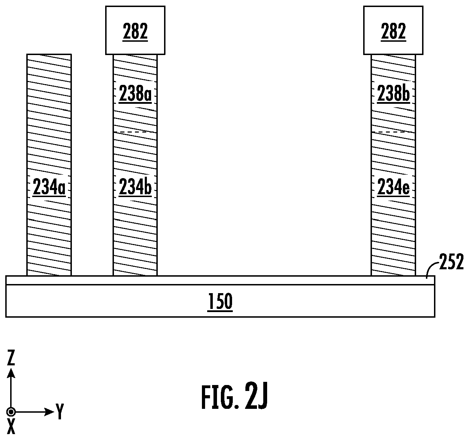

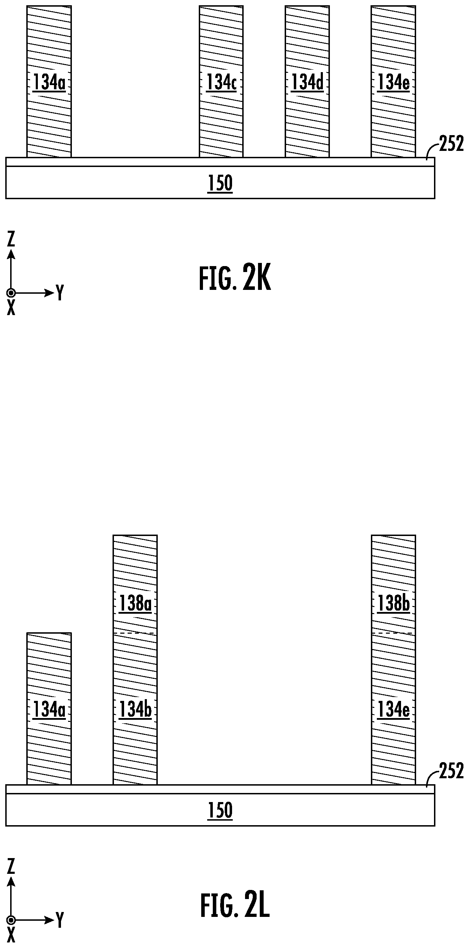

As shown in FIGs. 2J-2L and 4, a top via 138 may be formed (Block 418) in at least one of the signal-line areas 132 (FIG. 1B) after removing the dummy metal lines 276. FIG. 2K is a cross-sectional view showing an operation that occurs along line A-A' (FIG. 2C) after removing the dummy metal line 276a. FIGs. 2J and 2L are cross-sectional views showing operations that occur along line B-B' (FIG. 2C) after removing the dummy metal lines 276c, 276d. As shown in FIG. 2J, a blocking pattern 282 is formed on uppermost surfaces of the via positions 238a, 238b of the metal lines 234b, 234e. The blocking pattern 282 may be an insulating material that has an etch selectivity relative to the metal lines 234 and relative to the adhesion layer 252. As shown in FIGs. 2J-2L, top vias 138a, 138b may be formed by subtractive top-via patterning, which may include recessing (e.g., performing a subtractive metal etch of) top portions of metal lines 234 that are not vertically overlapped by the blocking pattern 282. The recessed metal lines 234 comprise metal signal lines 134. For example, a signal line 134c may be formed by recessing a top portion of the metal line 234c, and a signal line 134d may be formed by recessing a top portion of the metal line 234d, after removing the dummy metal lines 276.

The vias 138a, 138b are top portions (i.e., via positions 238a, 238b) of the metal lines 234b, 234e that are blocked from the recessing by the blocking pattern 282. In contrast, top portions (e.g., uppermost surfaces) of the metal lines 234 that are exposed by the blocking pattern 282 are recessed. The via 138a is spaced apart from the via 138b in the direction Y. Moreover, the signal line 134c is in a signal-line area 132c (FIG. 1B) comprising an opening 136c (FIG. 1B) that is between, in the direction Y, the vias 138a, 138b. Also, the signal line 134d is in a signal-line area 132d (FIG. 1B) comprising an opening 136d (FIG. 1B) that is between, in the direction Y, the vias 138a, 138b. The openings 136 that exist after forming the signal lines 134 and the vias 138 may be the same (i.e., may be in the same positions and have the same dimensions) as the openings 236 (FIG. 2A) that exist before forming the dummy metal lines 276 and that are reformed by removing the dummy metal lines 276.

After (i) performing metal patterning, (ii) removing the dummy metal lines 276, and (iii) forming the vias 138, the signal lines 134 may have a pitch 140 (FIG. 1B) in the direction Y. The pitch 140 may be constant because none of the signal lines 134 is wider, in the direction Y, than any of the other signal lines 134. In contrast, if metal patterning were performed on the non-full-track standard cell 260 (FIG. 2A), then some of the signal lines 134 may be wider than others.

For example, to address large spaces between metal lines 234 (e.g., due to openings 236 in the metal lines 234) of the non-full-track standard cell 260, optical proximity correction (OPC) may be used and may decrease (or reduce/prevent an increase in) widths, in the direction Y, of ones of the metal lines 234 that are adj acent the openings 236 in the direction Y. As an example, OPC (e.g., catastrophic OPC) may be used to increase patterning margin at a wide-space area when using a LELE process for metal patterning of the non-full-track standard cell 260. Without OPC, metal may expand/bulge in the wide-space area. Similarly, when using an SAUP (e.g., an SA-LELE) process for metal patterning of the non-full-track standard cell 260, a width of a metal line 234 (e.g., a non-mandrel metal line) adjacent a wide space (e.g., a wide gap between metal lines 234) may be enlarged relative to a width of a metal line 234 (e.g., another non-mandrel metal line) adjacent a narrow space. Performing metal patterning based on a design of the full-track standard cell 262 (which has no openings 236, and thus no wide-space areas between metal lines 234), however, can avoid metal enlargement, regardless of whether a LELE process or an SAUP process is used for the metal patterning.

As shown in FIGs. 2M, 2N, and 4, an insulating layer 156 may be formed (Block 420) on the structures shown in FIGs. 2K, 2L. FIG. 2M is a cross-sectional view showing an operation that occurs along line A-A' (FIG. 2C) after forming top vias 138. FIG. 2N is a cross-sectional view showing an operation that occurs along line B-B' (FIG. 2C) after forming the vias 138. As shown in FIGs. 2M and 2N, the insulating layer 156 may be formed on sidewalls of the signal lines 134, sidewalls of the vias 138, and uppermost surfaces of the signal lines 134. For example, the insulating layer 156 may be formed to fill spaces between sidewalls of the signal lines 134, and between sidewalls of the vias 138.

In some embodiments, the insulating layer 156 may be formed by performing a low-k material fill on the signal lines 134 and the vias 138. As used herein, the term "low-k" refers to a material that has a smaller dielectric constant than silicon dioxide. The low-k material may include, for example, fluorine-doped silicon dioxide, organosilicate glass, carbon-doped oxide, porous silicon dioxide, porous organosilicate glass, a spin-on organic polymeric dielectric, or a spin-on silicon based polymeric dielectric. Moreover, the insulating layer 156 may comprise a nitride layer.

Before forming the insulating layer 156, a metal adhesion layer 154 may be conformally formed on the signal lines 134 and the vias 138. For example, the adhesion layer 154 may be formed on sidewalls and uppermost surfaces of the via 138, and sidewalls of the signal lines 134. In some embodiments, the adhesion layer 154 may comprise nitride (e.g., metal nitride) and may be formed by conformal nitride deposition. The insulating layer 156 may then be formed on the adhesion layer 154.

Before forming the adhesion layer 154 and the insulating layer 156, the adhesion layer 252 may be patterned/etched to form a metal adhesion layer 152, which includes segments that are spaced apart from each other in the direction Y. The adhesion layer 152 may contact lowermost surfaces of the signal lines 134 and an uppermost surface of the insulating layer 150.

After forming the adhesion layer 154 and the insulating layer 156, the non-full-track standard cell 160 shown in FIGs. 1B-1D may be provided. For simplicity of illustration, the adhesion layer 154 and the insulating layer 156 are omitted from view in FIG. 1B.

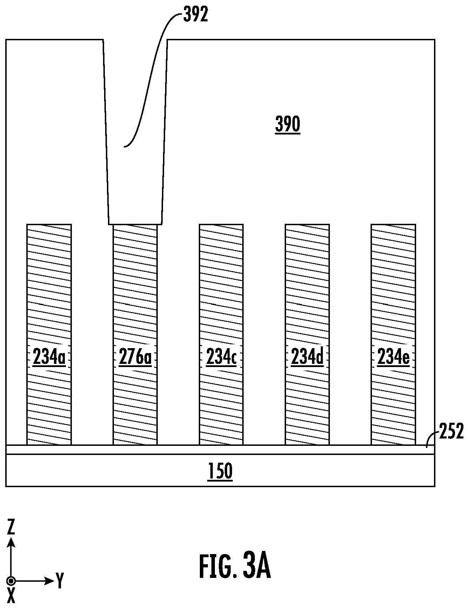

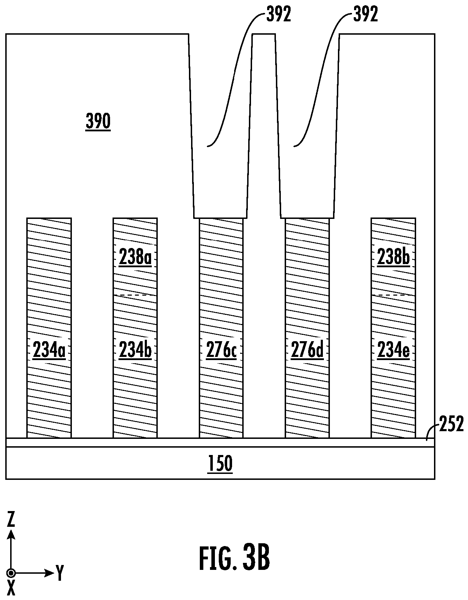

FIGs. 3A and 3B are cross-sectional views illustrating an operation of removing dummy metal lines 276 (FIGs. 2D and 2E) according to some embodiments herein. In some embodiments, the operation shown in FIGs. 3A and 3B may be performed instead of the operation shown in FIGs. 2F and 2G. The operation shown in FIGs. 3A and 3B is thus one example of how the dummy metal lines 276 may be removed, and the operation shown in FIGs. 2F and 2G is another example of how the dummy metal lines 276 may be removed.

FIG. 3A is a cross-section along line A-A' of FIG. 2C, and FIG. 3B is a cross-section along line B-B' of FIG. 2C. As shown in FIGs. 3A and 3B, an insulating material 390 may be formed on sidewalls and uppermost surfaces of the metal structures (e.g., metal lines 234 and dummy metal lines 276) shown in FIGs 2D and 2E. The uppermost surfaces of the dummy metal lines 276 may then be exposed by forming openings (e.g., by etching trenches) in the insulating material 390. Next, the dummy metal lines 276 may be removed (e.g., by a subtractive metal etch) through the openings 392 while the insulating material 390 is on the uppermost surfaces and the sidewalls of the metal lines 234, and then the insulating material 390 may be removed, thereby resulting in the structures shown in FIGs. 2H and 2I.

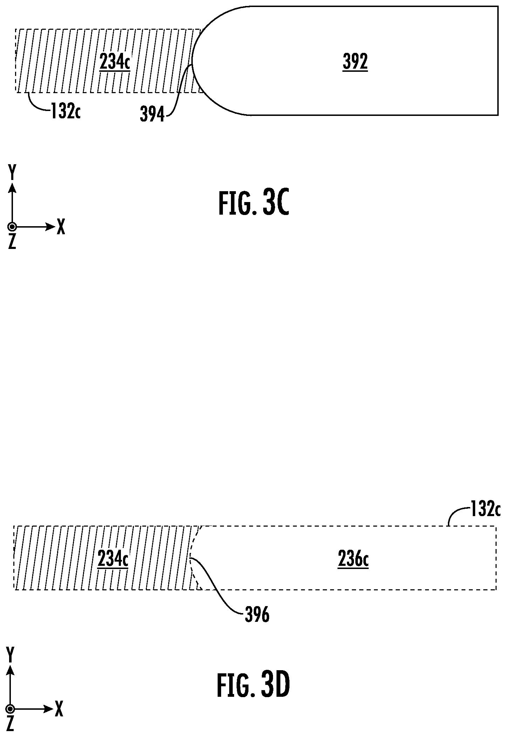

FIGs. 3C and 3D are plan views of a signal-line area 132c from which a dummy metal line 276 is removed using the operation shown in FIGs. 3A and 3B according to some embodiments herein. Referring to FIGs. 3B and 3C together with FIG. 2C, the insulating material 390 may be formed on the metal line 234c and on the dummy metal line 276c. An opening 392 is then formed in the insulating material 390 to expose the uppermost surface of the dummy metal line 276c, while the insulating material 390 remains on the metal line 234c.

As shown in FIG. 3C, the opening 392 may be wider, in the direction Y, than the signal-line area 132c. Moreover, an end portion of the opening 392 may have a curved shape 394 that borders the metal line 234c. For example, the curved shape 394 may be convex. After exposing the uppermost surface of the dummy metal line 276c through the opening 392, the dummy metal line 276c is removed (e.g., by a subtractive metal etch) through the opening 392. For simplicity of illustration, the dummy metal line 276c is not shown in FIG. 3C, and the insulating material 390 is not shown over the metal line 234c.

As shown in FIG. 3D, the removal of the dummy metal line 276c through the opening 392 forms an opening 236c in the signal-line area 132c. An end portion of the opening 236c may have the same curved shape as the curved shape 394 of the opening 392. Before removing the insulating material 390, the opening 392 vertically overlaps the opening 236c. Moreover, the end portion of the opening 392 may vertically overlap an adjacent end portion of the metal line 234c, and removal of the dummy metal line 276c through the opening 392 may thus form a curved (e.g., concave) surface 396 in the end portion of the metal line 234c, where the shape of the curved surface 396 is defined by the curved shape 394 of the opening 392. Accordingly, removing dummy metal lines 276 using the operation shown in FIGs. 3A and 3B may result in curved end portions of metal lines 234 bordering openings 236, whereas removing dummy metal lines 276 using the operation shown in FIGs. 2F and 2G may result in planar end portions of metal lines 234 bordering the openings 236.

IC devices 100 (FIG. 1A) according to embodiments herein may provide a number of advantages. These advantages include combining the benefits of two different standard cell designs for a BEOL region 130 (FIG. 1A) of an IC device 100. The first design is a non-full-track standard cell 260 (FIG. 2A), and the second design is a full-track standard cell 262 (FIG. 2B) that is formed by adding dummy metal lines 276 to the non-full-track standard cell 260. By performing metal patterning using the full-track standard cell 262 (rather than the non-full-track standard cell 260), metal patterning margin may increase. The full-track standard cell 262, however, can degrade performance of the IC device 100 by increasing capacitance (due to the increased amount of metal in the full-track standard cell 262).

Embodiments herein may integrate these two designs by converting the non-full-track standard cell 260 to the full-track standard cell 262 before performing metal patterning, and then converting the full-track standard cell 262 back into the non-full-track standard cell 260 by removing the dummy metal lines 276 after performing the metal patterning. Removing the dummy metal lines 276 can increase performance of the IC device 100 by reducing capacitance. This can help to increase the manufacturability of metal signal lines 134 (FIG. 1B) having a narrow pitch.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. A method of forming a back-end-of-line, BEOL, region of an integrated circuit device, the method comprising:
converting a non-full-track standard cell designed for the BEOL region to a full-track standard cell by adding dummy metal lines to the non-full-track standard cell;
performing metal patterning based on the full-track standard cell;
removing the dummy metal lines after performing the metal patterning; and
forming top vias after removing the dummy metal lines.

2. The method of Claim 1, wherein removing the dummy metal lines comprises performing a subtractive metal etch of the dummy metal lines.

3. The method of Claim 2, wherein removing the dummy metal lines further comprises forming a blocking pattern that vertically overlaps non-dummy metal lines of the full-track standard cell and does not vertically overlap the dummy metal lines,
wherein the blocking pattern is absent from sidewalls of the dummy metal lines, and
wherein the subtractive metal etch of the dummy metal lines is performed while the blocking pattern vertically overlaps the non-dummy metal lines.

4. The method of Claim 2, wherein removing the dummy metal lines further comprises:
forming an insulating material on uppermost surfaces and sidewalls of the dummy metal lines and on uppermost surfaces and sidewalls of non-dummy metal lines of the full-track standard cell; and
etching the insulating material to form openings in the insulating material that expose the uppermost surfaces of the dummy metal lines, and
wherein the subtractive metal etch of the dummy metal lines is performed through the openings while the insulating material is on the uppermost surfaces and the sidewalls of the non-dummy metal lines.

5. The method of Claim 4, wherein the subtractive metal etch forms a concave end portion of one of the non-dummy metal lines.

6. The method of any one of Claims 2 to 5, wherein the subtractive metal etch comprises a subtractive ruthenium, Ru, etch of the dummy metal lines.

7. The method of any one of Claims 1 to 6, wherein forming the top vias comprises performing
subtractive top-via patterning after removing the dummy metal lines.

8. The method of Claim 7, wherein performing the subtractive top-via patterning comprises:
forming a first metal signal line and a second metal signal line by recessing a top portion of a first non-dummy metal line and a top portion of a second non-dummy metal line, respectively, after removing the dummy metal lines; and
forming a first top via and a second top via by blocking a top portion of a third non-dummy metal line and a top portion of a fourth non-dummy metal line, respectively, from the recessing.

9. The method of Claim 8, wherein the first top via is spaced apart from the second top via in a lateral direction, and
wherein the first metal signal line is in a signal-line area comprising an opening that is between, in the lateral direction, the first top via and the second top via.

10. The method of any one of Claims 1 to 9, wherein removing the dummy metal lines converts the full-track standard cell back into the non-full-track standard cell.

11. The method of Claim 10, wherein, after removing the dummy metal lines, signal lines of the non-full-track standard cell have a constant pitch.

12. The method of any one of Claims 1 to 11, further comprising, before adding the dummy metal lines, designing the non-full-track standard cell;
wherein adding the dummy metal lines comprises designing metal in all openings in signal-line areas of the non-full-track standard cell,
wherein designing the non-full-track standard cell and adding the dummy metal lines are performed digitally, and
wherein performing the metal patterning based on the full-track standard cell comprises physically forming the full-track standard cell

13. The method of any one of Claims 1 to 12, wherein performing the metal patterning based on the full-track standard cell comprises performing self-aligned universal patterning, SAUP, to form the full-track standard cell.

14. The method of any one of Claims 1 to 12, wherein performing the metal patterning based on the full-track standard cell comprises performing litho-etch-litho-etch, LELE, patterning to form the full-track standard cell.

15. The method of any one of Claims 1 to 12, wherein performing the metal patterning based on the full-track standard cell comprises performing ruthenium, Ru, patterning to form the full-track standard cell.
